# EUROPÄISCHE PATENTANMELDUNG

(11) **EP 0 952 599 A2**
(43) Veröffentlichungstag der Anmeldung: **27.10.1999**
(21) Anmeldenummer: 99810269.3
(22) Anmeldetag: 29.03.1999
(51) Int. Cl.: H01H 13/70

(54) **Drucktastenschalter**

(30) Priorität: 20.04.1998 CH 89498
(71) Anmelder: Company for Technology Transfer and Patents Sark-Kistner, 1736 St. Silvester (CH)
(72) Erfinder: Sark, Werner, //// (CH)

(57) **Zusammenfassung**

Durch die Ausnützung der Durchbiegung einer dünnen Glasscheibe im Bereich eines Betätigungsfeldes können komplette, vandalensichere Tastaturen und Einzeltaster hergestellt werden.

## Beschreibung

Bisherige Taster (Schalter) bzw. Tastaturen bestehen aus mechanischen Tastern, sie sind nicht verschleissfrei und vandalensicher. Diese Taster bzw. Tastaturen in der Schutzart IP65 auszuführen war zum Teil nicht möglich oder teuer. Die auf dem Markt erhältlichen Sensortaster haben diese Nachteile nicht, können aber mit Handschuhen nicht betätigt werden. Abhilfe brachten die Matrix-Dünnglastastaturen, die weitgehend vandalensicher sind und von der Betätigungsseite her in der Schutzart IP65 geliefert werden können. Die Herstellung dieser Dünnglastastaturen ist aufwendig, einzelne Tastelemente herzustellen ist teuer.

Glas ist elastisch. Die durch den Betätigungsdruck an einer Tastfläche entstehende Durchbiegung des Glases wird dabei in ein Signal umgewandelt. In einer dicken Glasscheibe sind Oeffnungen, die durch eine weitere dünnere Glasscheibe ohne Oeffnungen bedeckt ist. Durch den Betätigungsdruck auf die dünnere Glasscheibe im Bereich der Aussparungen in der Dickglasscheibe entsteht eine Durchbiegung der dünnen Glasscheibe. Diese Durchbiegung der Glasscheibe wird nun durch Dehnmessstreifen, Piezo-,Opto-Sensoren, kapazitive, induktive, pneumatische, elektro-magnetische Sensoren, Mikroschalter, usw. in Signale umgewandelt. Es können durch diese Durchbiegung auch zwei leitende Flächen miteinander zur Kontaktabgabe verbunden bzw. Dünnglaskontakte verwendet werden. Ein pneumatisches Signal kann z.B. in einer explosionsgeschützten Anlage ohne Zwischenschaltung eines elektrischen Signals direkt weiter verarbeitet werden.

Der Vorteil dieser Tastatur: Sie besteht nur noch aus einer Glas- bzw. Verbundglasfläche, sie ist vandalensicher, leicht zu reinigen und kann durch die Hinterlegung von graphisch gestalteten Folien gekennzeichnet werden. Durch diese Technik lassen sich nicht nur graphisch gestaltete Komplett-Tastaturen, sondern auch einzelne Elemente einfach herstellen. Diese Tastaturen bzw. Einzelelemente können in jeder gewünschten Schutzart, sogar gekapselt, ausgeführt werden. Die gewünschten Graphiken oder Kennzeichnungen können direkt auf die Glasoberfläche, oder auf graphisch gestaltete Folien zwischen den Scheiben oder hinter der Verbundglasscheibe (leicht auswechselbar) auf- bzw. angebracht werden.

Die Glasscheiben können durch andere geeignete Materialien wie Kunststoffe, Metalle oder deren Kombination ersetzt bzw. kombiniert werden.

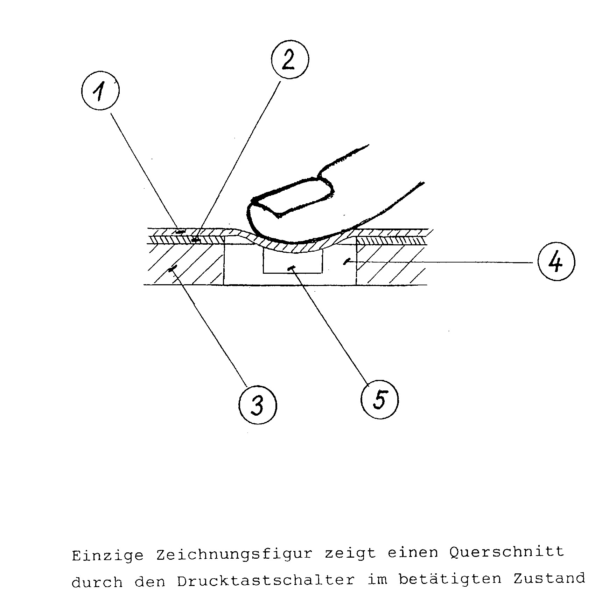

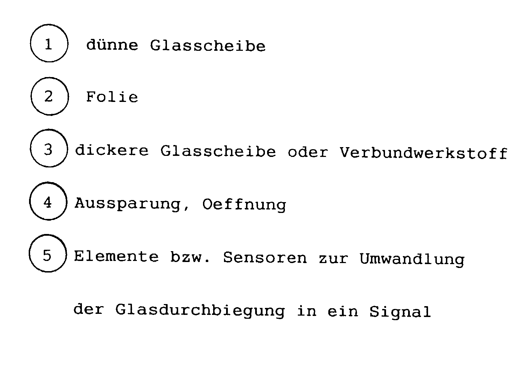

## Patentansprüche

1. Vandalensicher in einer Platte angeordneter Drucktastschalter, dadurch gekennzeichnet, dass über einer dicken Platte (3) eine dünne Scheibe (1) angebracht ist, wobei im Schaltbereich die dicke Platte (3) mit einer Oeffnung (4) versehen ist, in welcher die Biegung der dünnen Scheibe (1) in ein Signal zur Betätigtung der Schalteinrichtung (5) umgewandelt wird.

2. Schalter nach Anspruch 1, dadurch gekennzeichnet, dass die dünne Scheibe (1) und/oder die dicke Platte (3) aus bruchsicherem Glas bestehen.

3. Schalter nach Anspruch 1 oder 2, dadurch gekennzeichnet, dass die dünne Scheibe (1) und/oder die dicke Platte (3) aus Kunststoff, Metall oder Verbundwerkstoffen bestehen.

4. Schalter nach einem der Ansprüche 1 bis 3, dadurch gekennzeichnet, dass die Schalteinrichtung (5) auf die Durchbiegung der dünnen Scheibe (1) ansprechende Dehnmessstreifen, Piezo-, Opto-, kapazitive-, induktive-, pneumatische Sensoren, Mikroschalter oder zwei beispielsweise durch Dünnglaskontakte verbindbare Leitflächen aufweist.

5. Schalter nach einem der Ansprüche 1 bis 3, dadurch gekennzeichnet, dass die Schalteinrichtung (5) durch das menschliche Magnetfeld beeinflussbare elektromagnetische Sensoren aufweist.

6. Schalter nach einem der Ansprüche 1 bis 5, dadurch gekennzeichnet, dass Grafiken und/oder Kennzeichnungen direkt auf der Oberfläche der dünnen Scheibe (1) oder der dicken Platte (3) oder auf einer mit ihnen verbundenen Folie angebracht sind.
